# EUROPEAN PATENT APPLICATION

(11) **EP 4 651 212 A1**
(43) Date of publication of application: **19.11.2025**
(21) Application number: 24752718.7
(22) Date of filing: 29.01.2024
(51) Int. Cl.: H01L 31/18, H01L 31/0216, H01L 31/0224, H01L 31/06

(54) **SOLAR CELL AND PREPARATION METHOD THEREFOR**

(30) Priority: 08.02.2023 CN 202310132510
(71) Applicant: Tongwei Solar (Chengdu) Co., Ltd., Chengdu, Sichuan 610299 (CN)
(72) Inventor: HAN, Zongyu, Chengdu, Sichuan 610299 (CN); XU, Lei, Chengdu, Sichuan 610299 (CN); WANG, Jin, Chengdu, Sichuan 610299 (CN)
(74) Representative: Michalski Hüttermann & Partner Patentanwälte mbB
(86) International application number: PCT/CN2024/074400
(87) International publication number: WO 2024/164862

(57) **Abstract**

The present application provides a solar cell and a preparation method therefor. The preparation method comprises: respectively depositing a first intrinsic amorphous silicon layer and a second intrinsic amorphous silicon layer on the front surface and the back surface of a monocrystalline silicon substrate; depositing an n-type doped amorphous silicon layer on the first intrinsic amorphous silicon layer; depositing a p-type doped amorphous silicon layer on the second intrinsic amorphous silicon layer; depositing an n-type doped microcrystalline silicon layer on the n-type doped amorphous silicon layer; depositing a p-type doped microcrystalline silicon layer on the p-type doped amorphous silicon layer; and performing alkali polishing on the n-type doped microcrystalline silicon layer and the p-type doped microcrystalline silicon layer by using an alkali solution. The prepared solar cell has good photoelectric performance and high conversion efficiency.

## Description

This application claims priority to Chinese Patent Application No. 2023101325103, entitled "SOLAR CELL AND PREPARATION METHOD THEREFOR", filed on February 8, 2023, the content of which is incorporated herein by reference in its entirety.

### TECHNICAL FIELD

The present disclosure relates to the field of photovoltaic technology, and in particular to a solar cell and a method for preparing the same.

### BACKGROUND

As the efficiency of RESH (Rear Emitter Si Heterojunction) cells continues to improve and the cost continues to decrease, the market share of high-efficiency RESH cells is also increasing.

However, in order to better meet market needs, the photoelectric performance and conversion efficiency of microcrystalline RESH cells still need to be further improved. Therefore, how to further improve the photoelectric performance and conversion efficiency of RESH cells has become one of the research hotspots in the art.

### SUMMARY

Accordingly, it is necessary to provide a solar cell with good photoelectric performance and high conversion efficiency and a method for preparing the same.

A technical solution proposed in the present disclosure is described below.

According to a first aspect of the present disclosure, a method for preparing a solar cell is provided, including:
providing a textured monocrystalline silicon substrate;
depositing a first intrinsic amorphous silicon layer and a second intrinsic amorphous silicon layer on a front side and a back side of the monocrystalline silicon substrate, respectively;
depositing an n-type doped amorphous silicon layer on the first intrinsic amorphous silicon layer by a PECVD method; depositing a p-type doped amorphous silicon layer on the second intrinsic amorphous silicon layer by a PECVD method;
depositing an n-type doped microcrystalline silicon layer on the n-type doped amorphous silicon layer by a PECVD method; depositing a p-type doped microcrystalline silicon layer on the p-type doped amorphous silicon layer by a PECVD method; wherein a gas pressure for depositing the n-type doped microcrystalline silicon layer and the p-type doped microcrystalline silicon layer is 3 Torr to 5 Torr, a flow ratio of SiH₄, doping gas, and H₂ in a process gas is 1: (1-1.5): (150-200), an ignition power is 2000 W to 3500 W, and an ignition time is 100 s to 230 s;
alkaline polishing the n-type doped microcrystalline silicon layer and the p-type doped microcrystalline silicon layer using an alkaline solution;
depositing transparent conductive films on the n-type doped microcrystalline silicon layer and the p-type doped microcrystalline silicon layer after alkaline polishing, respectively; and
preparing an electrode on the transparent conductive films.

In the preparation method of the present disclosure, by regulating the deposition process parameters of the microcrystalline silicon layer and depositing the n-type doped microcrystalline silicon layer and the p-type doped microcrystalline silicon layer under specific gas pressure, gas ratio, ignition power and ignition time, the crystallization rate of the microcrystalline silicon layer is improved. In addition, the thickness of the microcrystalline silicon layer is thinned by steps such as alkaline polishing, thereby avoiding the adverse effects of excessive thickness of the microcrystalline silicon layer on cell performance, reducing damage to the microcrystalline silicon layer and lowering the defective ratio. The above-mentioned preparation method can effectively improve the photoelectric performance and conversion efficiency of microcrystalline RESH cells.

In some embodiments, the alkaline solution is an alkali metal hydroxide solution with a mass fraction of 0.5% to 1.2%. By performing alkaline polishing treatment on the n-type doped microcrystalline silicon layer and the p-type doped microcrystalline silicon layer using a low concentration of alkaline solution, the microcrystalline silicon layer can be thinned at a suitable rate, which avoids anisotropic corrosion of the microcrystalline silicon layer, improves the quality of the microcrystalline silicon layer after alkaline polishing, and makes it easy to control the thickness of film layer.

In some embodiments, a temperature of alkaline polishing is 45°C to 60°C. By controlling the temperature of alkaline polishing at the aforementioned relatively low temperature, the corrosion and thinning rate of the microcrystalline silicon layer can be further moderate, the quality of the microcrystalline silicon layer after alkaline polishing can be further improved, and the thickness of film layer can be more easily controlled.

In some embodiments, prior to alkaline polishing, a thickness of the n-type doped microcrystalline silicon layer is 100 nm to 150 nm, and a thickness of the p-type doped microcrystalline silicon layer is 100 nm to 150 nm. When the process conditions for depositing the n-type doped microcrystalline silicon layer and the p-type doped microcrystalline silicon layer are determined, the thicknesses of the deposited n-type doped microcrystalline silicon layer and the deposited p-type doped microcrystalline silicon layer can be controlled within the aforementioned range by controlling the ignition time.

In some embodiments, after alkaline polishing, the thickness of the n-type doped microcrystalline silicon layer is 40 nm to 70 nm, and the thickness of the p-type doped microcrystalline silicon layer is 40 nm to 70 nm. By keeping the thicknesses of the n-type doped microcrystalline silicon layer and the p-type doped microcrystalline silicon layer both within the aforementioned range through alkaline polishing, the photoelectric performance and conversion efficiency of RESH cells can be effectively improved.

In some embodiments, a gas pressure for depositing the n-type doped amorphous silicon layer is 0.50 Torr to 0.57 Torr, a flow ratio of SiH₄, doping gas, and H₂ in a process gas is 1: (0.25-1): (1-1.5), an ignition power is 200 W to 800 W, and an ignition time is 20 s to 35 s.

In some embodiments, a gas pressure for depositing the p-type doped amorphous silicon layer is 0.50 Torr to 0.57 Torr, a flow ratio of SiH₄, doping gas, and H₂ in a process gas is 1: (0.25-1): (1-1.5), an ignition power is 200 W to 800 W, and an ignition time is 20 s to 35 s.

In some embodiments, a thickness of the n-type doped amorphous silicon layer is 3 nm to 8 nm.

In some embodiments, a thickness of the p-type doped amorphous silicon layer is 3 nm to 8 nm.

In some embodiments, after alkaline polishing and prior to depositing transparent conductive films, the method further includes a step of cleaning the n-type doped microcrystalline silicon layer and the p-type doped microcrystalline silicon layer.

In some embodiments, a cleaning solution used in the cleaning is an acid solution containing hydrogen peroxide.

In some embodiments, after cleaning and prior to depositing transparent conductive films, the method further includes a step of passivating the n-type doped microcrystalline silicon layer and the p-type doped microcrystalline silicon layer.

In some embodiments, a passivation solution used in the passivating is a hydrofluoric acid solution.

In some embodiments, the first intrinsic amorphous silicon layer includes three intrinsic amorphous silicon layers sequentially deposited on the front side of the monocrystalline silicon substrate.

Process gases for depositing a first layer of intrinsic amorphous silicon are SiH₄ and CO₂, a process gas pressure is 0.5 Torr to 0.57 Torr, an ignition power is 600 W to 800 W, a flow ratio of SiH₄ and CO₂ is 1:1 to 1.5, and an ignition time is 5 s to 8 s.

A process gas for depositing a second layer of intrinsic amorphous silicon is SiH₄, a process gas pressure is 0.5 Torr to 0.57 Torr, an ignition power is 600 W to 800 W, and an ignition time is 8 s to 13 s.

Process gases for depositing a third layer of intrinsic amorphous silicon are SiH₄ and H₂, a process gas pressure is 0.5 Torr to 0.57 Torr, an ignition power is 600W to 800 W, a flow ratio of SiH₄ and H₂ is 1:1 to 1.5, and an ignition time is 3 s to 7 s.

In some embodiments, the second intrinsic amorphous silicon layer includes three intrinsic amorphous silicon layers sequentially deposited on the back side of the monocrystalline silicon substrate.

Process gases for depositing a first layer of intrinsic amorphous silicon are SiH₄ and CO₂, a process gas pressure is 0.5 Torr to 0.57 Torr, an ignition power is 600 W to 800 W, a flow ratio of SiH₄ and CO₂ is 1:1 to 1.5, and an ignition time is 5 s to 8 s.

A process gas for depositing a second layer of intrinsic amorphous silicon is SiH₄, a process gas pressure is 0.5 Torr to 0.57 Torr, an ignition power is 600 W to 800 W, and an ignition time is 8 s to 13 s.

Process gases for depositing a third layer of intrinsic amorphous silicon are SiH₄ and H₂, a process gas pressure is 0.5 Torr to 0.57 Torr, an ignition power is 600W to 800 W, a flow ratio of SiH₄ and H₂ is 1:1 to 1.5, and an ignition time is 3 s to 7 s.

According to a second aspect of the present disclosure, a solar cell is provided. The solar cell is prepared by the method for preparing the solar cell according to the first aspect of the present disclosure. The solar cell has good photoelectric performance and conversion efficiency.

In some embodiments, the solar cell includes a monocrystalline silicon substrate, a first intrinsic amorphous silicon layer, a second intrinsic amorphous silicon layer, an n-type doped amorphous silicon layer, a p-type doped amorphous silicon layer, an n-type doped microcrystalline silicon layer, a p-type doped microcrystalline silicon layer, a first transparent conductive film, a second transparent conductive film, a first electrode, and a second electrode.

The first intrinsic amorphous silicon layer, the n-type doped amorphous silicon layer, the n-type doped microcrystalline silicon layer, the first transparent conductive film, and the first electrode are sequentially stacked on a front side of the monocrystalline silicon substrate.

The second intrinsic amorphous silicon layer, the p-type doped amorphous silicon layer, the p-type doped microcrystalline silicon layer, the second transparent conductive film, and the second electrode are sequentially stacked on a back side of the monocrystalline silicon substrate.

In some embodiments, a thickness of the n-type doped microcrystalline silicon layer and a thickness of the p-type doped microcrystalline silicon layer are each independently 40 nm to 70 nm.

In some embodiments, a crystallization rate of the n-type doped microcrystalline silicon layer and a crystallization rate of the p-type doped microcrystalline silicon layer are each independently 45% to 55%.

In some embodiments, a thickness of the n-type doped amorphous silicon layer and a thickness of the p-type doped amorphous silicon layer are each independently 3 nm to 8 nm.

### BRIEF DESCRIPTION OF THE DRAWINGS

To better describe and illustrate embodiments and/or examples of the disclosure, reference may be made to one or more accompanying drawings. The additional details or examples used to describe the accompanying drawings are not to be construed as limiting the scope of any one of the disclosures, the presently described embodiments and/or examples, and the presently understood preferred modes of the disclosures.
FIG. 1 is a flow chart of a method for preparing a solar cell according to an embodiment of the present disclosure.
FIG. 2 is a schematic view of a solar cell according to an embodiment of the present disclosure.

Reference Numerals:
11, monocrystalline silicon substrate; 12, first intrinsic amorphous silicon layer; 13, second intrinsic amorphous silicon layer; 14, n-type doped amorphous silicon layer; 15, p-type doped amorphous silicon layer; 16, n-type doped microcrystalline silicon layer; 17, p-type doped microcrystalline silicon layer; 18, first transparent conductive film; 19, second transparent conductive film; 20, first electrode; 21, second electrode; 100, solar cell.

### DETAILED DESCRIPTION

In order to make the above objectives, features and advantages of the present disclosure more obvious and understandable, specific embodiments of the present disclosure are described in detail below. In the following description, many specific details are set forth in order to fully understand the present disclosure. However, the present disclosure can be implemented in many other ways different from those described herein, and those skilled in the art can make similar improvements without departing from the connotation of the present disclosure. Therefore, the present disclosure is not limited by the specific embodiments disclosed below.

In addition, the terms "first" and "second" are used for descriptive purposes only, which cannot be construed as indicating or implying a relative importance, or implicitly specifying the number of the indicated technical features. Therefore, the features defined with "first" and "second" may explicitly or implicitly include at least one of the features. In the description of the present disclosure, "plurality" means at least two, such as two, three, etc., unless otherwise specifically defined.

In the present disclosure, the terms "mounting," "connecting together," "connecting," "fixing" and the like should be understood broadly. For example, it could be understood as a fixed connection, a detachable connection, or an integrated connection; it could be understood as a mechanical connection or an electrical connection; it could be understood as a direct connection or an indirect connection by an intermediate medium; and it could be understood as an internal communication between two elements or an interaction between two elements, unless otherwise expressly defined. For a person skilled in the art, the specific meaning of the aforementioned terms in the present disclosure can be understood according to specific situations.

All technical and scientific terms used herein have the same meaning as commonly understood by those of ordinary skill in the art to which the present disclosure applies, unless otherwise defined. The terms used in the specification of the present disclosure herein are for the purpose of describing specific embodiments only and are not intended to limit the present disclosure. The term "and/or" used herein includes any and all combinations of one or more of the associated listed items.

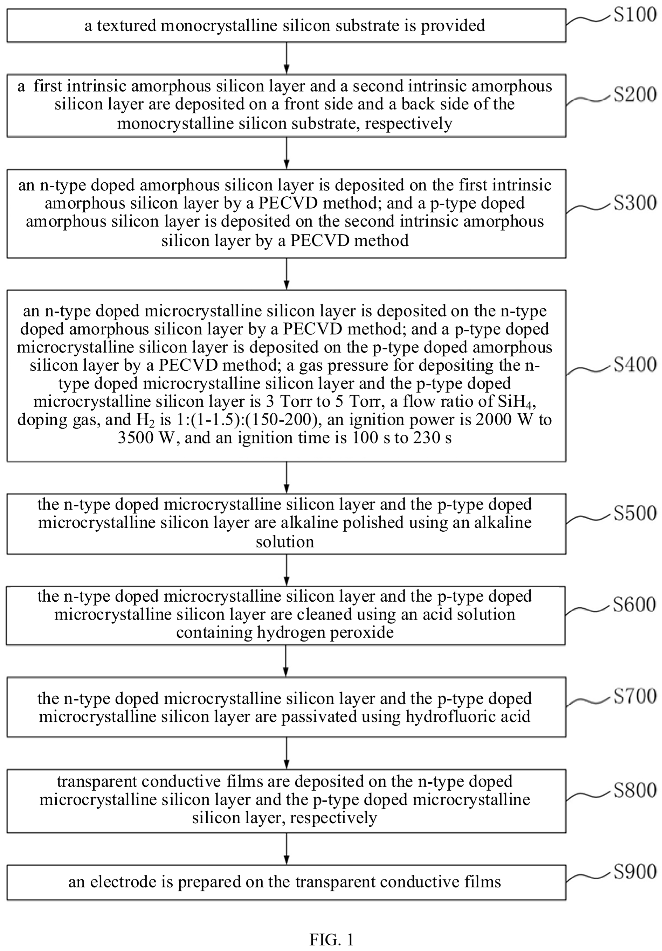

Referring to FIG. 1, a method for preparing a solar cell is provided according to some embodiments of the present disclosure. The preparation method includes the following steps S100 to S900:
Step S100: a textured monocrystalline silicon substrate is provided.

In some embodiments, a monocrystalline silicon wafer is subjected to a texturing and cleaning treatment using a texturing solution on a texturing and cleaning machine to form a textured structure on the surface of the monocrystalline silicon wafer, thereby obtaining the textured monocrystalline silicon substrate. In some specific examples, the monocrystalline silicon substrate is an n-type monocrystalline silicon substrate.

It should be noted that the resistivity of the monocrystalline silicon substrate, the specific equipment structure of the texturing and cleaning machine, and the process conditions of texturing and cleaning are not specifically limited in the present disclosure. The existing monocrystalline silicon substrate, texturing and cleaning machine and conventional texturing and cleaning process conditions may be used.

Step S200: a first intrinsic amorphous silicon layer and a second intrinsic amorphous silicon layer are deposited on a front side and a back side of the monocrystalline silicon substrate, respectively.

In some embodiments, the first intrinsic amorphous silicon layer and the second intrinsic amorphous silicon layer are respectively deposited on the front side and the back side of the textured monocrystalline silicon substrate by a PECVD (Plasma Enhanced Chemical Vapor Deposition) method.

It should be noted that the structure of the preparation machine and the preparation process conditions of the first intrinsic amorphous silicon layer and the second intrinsic amorphous silicon layer are not specifically limited in the present disclosure. Existing conventional equipment and process conditions for preparing an intrinsic amorphous silicon layer may be used.

In some embodiments, the first intrinsic amorphous silicon layer includes three intrinsic amorphous silicon layers sequentially deposited on the front side of the monocrystalline silicon substrate. Process gases for depositing a first layer of intrinsic amorphous silicon are SiH₄ and CO₂, a process gas pressure is 0.5 Torr to 0.57 Torr, an ignition power is 600 W to 800 W, a flow ratio of SiH₄ and CO₂ is 1:1 to 1.5, and an ignition time is 5 s to 8 s. A process gas for depositing a second layer of intrinsic amorphous silicon is SiH₄, a process gas pressure is 0.5 Torr to 0.57 Torr, an ignition power is 600 W to 800 W, and an ignition time is 8 s to 13 s. Process gases for depositing a third layer of intrinsic amorphous silicon are SiH₄ and H₂, a process gas pressure is 0.5 Torr to 0.57 Torr, an ignition power is 600W to 800 W, a flow ratio of SiH₄ and H₂ is 1:1 to 1.5, and an ignition time is 3 s to 7 s.

In some embodiments, the second intrinsic amorphous silicon layer includes three intrinsic amorphous silicon layers sequentially deposited on the back side of the monocrystalline silicon substrate. Process gases for depositing a first layer of intrinsic amorphous silicon are SiH₄ and CO₂, a process gas pressure is 0.5 Torr to 0.57 Torr, an ignition power is 600 W to 800 W, a flow ratio of SiH₄ and CO₂ is 1:1 to 1.5, and an ignition time is 5 s to 8 s. A process gas for depositing a second layer of intrinsic amorphous silicon is SiH₄, a process gas pressure is 0.5 Torr to 0.57 Torr, an ignition power is 600 W to 800 W, and an ignition time is 8 s to 13 s. Process gases for depositing a third layer of intrinsic amorphous silicon are SiH₄ and H₂, a process gas pressure is 0.5 Torr to 0.57 Torr, an ignition power is 600W to 800 W, a flow ratio of SiH₄ and H₂ is 1:1 to 1.5, and an ignition time is 3 s to 7 s.

Step S300: an n-type doped amorphous silicon layer is deposited on the first intrinsic amorphous silicon layer by a PECVD method; and a p-type doped amorphous silicon layer is deposited on the second intrinsic amorphous silicon layer by a PECVD method.

In the present disclosure, an n-type doped amorphous silicon layer is deposited on the first intrinsic amorphous silicon layer by a PECVD method as an incubation layer for a subsequent microcrystalline silicon layer; and a p-type doped amorphous silicon layer is deposited on the second intrinsic amorphous silicon layer by a PECVD method as an incubation layer for a subsequent microcrystalline silicon layer.

In some embodiments, a gas pressure for depositing the n-type doped amorphous silicon layer is 0.50 Torr to 0.57 Torr, a flow ratio of SiH₄, doping gas, and H₂ in the chamber atmosphere is 1:(0.25-1):(1-1.5), an ignition power is 200 W to 800 W, and an ignition time is 20 s to 35 s.

It can be understood that the gas pressure for depositing the n-type doped amorphous silicon layer can be, but is not limited to, 0.50 Torr, 0.51 Torr, 0.52 Torr, 0.53 Torr, 0.54 Torr, 0.55 Torr, 0.56 Torr, 0.57 Torr. The flow ratio of SiH₄ to doping gas (such as PH₃) in the chamber atmosphere can be, but is not limited to, 1:0.25, 1:0.3, 1:0.35, 1:0.4, 1:0.45, 1:0.5, 1:0.55, 1:0.6, 1:0.65, 1:0.7, 1:0.75, 1:0.8, 1:0.85, 1:0.9, 1:0.95, 1:1. The flow ratio of SiH₄ to H₂ can be, but is not limited to, 1:1, 1:1.1, 1:1.2, 1:1.3, 1:1.4, 1:1.5. The ignition power can be, but is not limited to, 200 W, 300 W, 400 W, 500 W, 600 W, 700 W, 800 W. The ignition time can be, but is not limited to 20 s, 22 s, 24 s, 26 s, 28 s, 30 s, 32 s, 34 s, 35 s.

In some embodiments, a gas pressure for depositing the p-type doped amorphous silicon layer is 0.50 Torr to 0.57 Torr, a flow ratio of SiH₄, doping gas, and H₂ in the chamber atmosphere is 1:(0.25-1):(1-1.5), an ignition power is 200 W to 800 W, and an ignition time is 20 s to 35 s.

It can be understood that the gas pressure for depositing the p-type doped amorphous silicon layer can be, but is not limited to, 0.50 Torr, 0.51 Torr, 0.52 Torr, 0.53 Torr, 0.54 Torr, 0.55 Torr, 0.56 Torr, 0.57 Torr. The flow ratio of SiH₄ to doping gas (such as B₂H₆) in the chamber atmosphere can be, but is not limited to, 1:0.25, 1:0.3, 1:0.35, 1:0.4, 1:0.45, 1:0.5, 1:0.55, 1:0.6, 1:0.65, 1:0.7, 1:0.75, 1:0.8, 1:0.85, 1:0.9, 1:0.95, 1:1. The flow ratio of SiH₄ to H₂ can be, but is not limited to, 1:1, 1:1.1, 1:1.2, 1:1.3, 1:1.4, 1:1.5. The ignition power can be, but is not limited to, 200 W, 300 W, 400 W, 500 W, 600 W, 700 W, 800 W. The ignition time can be, but is not limited to 20 s, 22 s, 24 s, 26 s, 28 s, 30 s, 32 s, 34 s, 35 s.

In some embodiments, a thickness of the deposited n-type doped amorphous silicon layer is 3 nm to 8 nm, and a thickness of the deposited p-type doped amorphous silicon layer is 3 nm to 8 nm.

It can be understood that when the process conditions for depositing the n-type doped amorphous silicon layer and the p-type doped amorphous silicon layer (such as the gas pressure in the chamber, the flow ratio of SiH₄ to H₂, and the ignition power) are determined, thicknesses of the deposited n-type doped amorphous silicon layer and the deposited p-type doped amorphous silicon layer can be controlled by controlling the ignition time. The longer the ignition time is, the thicker the n-type doped amorphous silicon layer and the p-type doped amorphous silicon layer will be.

Step S400: an n-type doped microcrystalline silicon layer is deposited on the n-type doped amorphous silicon layer by a PECVD method; and a p-type doped microcrystalline silicon layer is deposited on the p-type doped amorphous silicon layer by a PECVD method.

In some embodiments, a gas pressure in the chamber for depositing the n-type doped microcrystalline silicon layer is 3 Torr to 5 Torr, a flow ratio of SiH₄, doping gas (such as PH₃), and H₂ in the chamber atmosphere is 1:(1-1.5):(150-200), an ignition power is 2000 W to 3500 W, and an ignition time is 100 s to 230 s. In this way, by using high power, high H₂ ratio and high gas pressure, an n-type doped microcrystalline silicon layer with a high crystallization rate can be prepared. Within a certain crystallization range, the higher the crystallization rate, the narrower the optical band gap of the film and the smaller the absorption coefficient, thus the photoelectric performance and conversion efficiency of the solar cell can be improved.

It can be understood that the gas pressure in the chamber for depositing the n-type doped microcrystalline silicon layer can be, but is not limited to, 3 Torr, 3.2 Torr, 3.5 Torr, 3.8 Torr, 4 Torr, 4.2 Torr, 4.5 Torr, 4.8 Torr, 5 Torr. The flow ratio of SiH₄ to H₂ in the chamber atmosphere can be, but is not limited to, 1:150, 1:160, 1:170, 1:180, 1:190, 1:200. The flow ratio of SiH₄ to the doping gas can be, but is not limited to, 1:1, 1:1.1, 1:1.2, 1:1.3, 1:1.4, 1:1.5. The ignition power can be, but is not limited to, 2000 W, 2100 W, 2200 W, 2300 W, 2400 W, 2500 W, 2600 W, 2700 W, 2800 W, 2900 W, 3000 W, 3100 W, 3200 W, 3300 W, 3400 W, 3500 W. The ignition time can be, but is not limited to, 100 s, 110 s, 120 s, 130 s, 140 s, 150 s, 160 s, 170 s, 180 s, 190 s, 200 s, 210 s, 220 s, 230 s.

In some embodiments, a gas pressure in the chamber for depositing the p-type doped microcrystalline silicon layer is 3 Torr to 5 Torr, a flow ratio of SiH₄, doping gas (such as B₂H₆), and H₂ in the chamber atmosphere is 1:(1-1.5):150-200, an ignition power is 2000 W to 3500 W, and an ignition time is 100 s to 230 s. Similarly, by using high power, high H₂ ratio and high gas pressure, a p-type doped microcrystalline silicon layer with a high crystallization rate can be prepared, thus the photoelectric performance and conversion efficiency of the solar cell can be improved.

It can be understood that the gas pressure in the chamber for depositing the p-type doped microcrystalline silicon layer can be, but is not limited to, 3 Torr, 3.2 Torr, 3.5 Torr, 3.8 Torr, 4 Torr, 4.2 Torr, 4.5 Torr, 4.8 Torr, 5 Torr. The flow ratio of SiH₄ to H₂ in the chamber atmosphere can be, but is not limited to, 1:150, 1:160, 1:170, 1:180, 1:190, 1:200. The flow ratio of SiH₄ to the doping gas can be, but is not limited to, 1:1, 1:1.1, 1:1.2, 1:1.3, 1:1.4, 1:1.5. The ignition power can be, but is not limited to, 2000 W, 2100 W, 2200 W, 2300 W, 2400 W, 2500 W, 2600 W, 2700 W, 2800 W, 2900 W, 3000 W, 3100 W, 3200 W, 3300 W, 3400 W, 3500 W. The ignition time can be, but is not limited to, 100 s, 110 s, 120 s, 130 s, 140 s, 150 s, 160 s, 170 s, 180 s, 190 s, 200 s, 210 s, 220 s, 230 s.

In some embodiments, a thickness of the deposited n-type doped microcrystalline silicon layer is 100 nm to 150 nm, and a thickness of the deposited p-type doped microcrystalline silicon layer is 100 nm to 150 nm. The crystallization rates of the n-type doped microcrystalline silicon layer and the p-type doped microcrystalline silicon layer are both between 45% and 55%.

When the process conditions for depositing the n-type doped microcrystalline silicon layer and the p-type doped microcrystalline silicon layer (such as the gas pressure in the chamber, the flow ratio of SiH₄, doping gas and H₂, and the ignition power) are determined, thicknesses and crystallization rates of the deposited n-type doped microcrystalline silicon layer and the deposited p-type doped microcrystalline silicon layer can be controlled by controlling the ignition time. The longer the ignition time is, the thicker the n-type doped microcrystalline silicon layer and the p-type doped microcrystalline silicon layer will be. In addition, as the thickness of the microcrystalline silicon layer is increased, the crystallization rate of the microcrystalline silicon layer will also be increased.

It can be understood that the thickness of the n-type doped microcrystalline silicon layer can be, but is not limited to, 100 nm, 110 nm, 120 nm, 130 nm, 140 nm, 150 nm. The thickness of the p-type doped microcrystalline silicon layer can be, but is not limited to 100 nm, 110 nm, 120 nm, 130 nm, 140 nm, 150 nm.

Step S500: the n-type doped microcrystalline silicon layer and the p-type doped microcrystalline silicon layer are alkaline polished using an alkaline solution.

When the n-type doped microcrystalline silicon layers and the p-type doped microcrystalline silicon layers are deposited by a PECVD method under high ignition power, high H₂ ratio and high gas pressure, a microcrystalline silicon layer with a relatively high crystallization rate can be prepared, while the thickness of the microcrystalline silicon layer will be increased. A relatively thick microcrystalline silicon layer will cause the reduction of photoelectric performance and conversion efficiency of RESH cells.

In the present disclosure, after an n-type doped microcrystalline silicon layer and a p-type doped microcrystalline silicon layer are deposited by PECVD, the n-type doped microcrystalline silicon layer and the p-type doped microcrystalline silicon layer are subjected to an alkaline polishing treatment using an alkaline solution. The alkaline polishing treatment can effectively reduce the thickness of the n-type doped microcrystalline silicon layer and the p-type doped microcrystalline silicon layer, and reduce the excessive film thickness caused by increasing the crystallization rate to a suitable film thickness range, thereby facilitating the improvement of the photoelectric performance and conversion efficiency of RESH cells.

The main chemical reactions that occur during alkaline polishing are as follows (taking potassium hydroxide as an example):

2KOH+Si+H₂O=K₂SiO₃+2H₂

K₂SiO₃+3H₂O=H₄SiO₄+2KOH

H₄SiO₄=H₂SiO₃(metasilicic acid)+H₂O

H₂SiO₃+2KOH=K₂SiO₃+2H₂O

H₂SiO₃+KOH=KHSiO₃+H₂O

In some embodiments, the alkaline solution used in the alkaline polishing treatment is an alkali metal hydroxide solution with a mass fraction of 0.5% to 1.2%. During the alkaline polishing treatment, if the concentration of the alkaline solution used is too high, the corrosion rate of the microcrystalline silicon layer will be fast, resulting in anisotropic corrosion that causes great damage to the microcrystalline silicon layer. In addition, too fast the corrosion rate will also make it difficult to control the thickness of the microcrystalline silicon layer after alkaline polishing. In the present disclosure, by performing alkaline polishing treatment on the n-type doped microcrystalline silicon layer and the p-type doped microcrystalline silicon layer using a low concentration of alkaline solution, the microcrystalline silicon layer can be thinned at a suitable rate, which avoids anisotropic corrosion of the microcrystalline silicon layer, improves the quality of the microcrystalline silicon layer after alkaline polishing, and makes it easy to control the thickness of film layer.

It can be understood that the mass fraction of the alkaline solution can be, but is not limited to, 0.5%, 0.6%, 0.7%, 0.8%, 0.9%, 1.0%, 1.1%, and 1.2%. The alkaline solution may be an alkali metal hydroxide solution such as potassium hydroxide or sodium hydroxide.

In some embodiments, a temperature of the alkaline polishing treatment is 45°C to 60°C. If the temperature of the alkaline polishing treatment is too high, the corrosion rate of the microcrystalline silicon layer will also be too fast, making it difficult to control the thickness of the microcrystalline film layer. In the present disclosure, by controlling the temperature of alkaline polishing at a relatively low temperature of 45°C to 60°C, the corrosion and thinning rate of the microcrystalline silicon layer can be further moderate, the quality of the microcrystalline silicon layer after alkaline polishing can be further improved, and the thickness of film layer can be more easily controlled.

It can be understood that the temperature of the alkaline polishing treatment can be, but is not limited to, 45°C, 46°C, 47°C, 48°C, 49°C, 50°C, 51°C, 52°C, 53°C, 54°C, 55°C, 56°C, 57°C, 58°C, 59°C, and 60°C.

In some embodiments, after alkaline polishing, the thickness of the n-type doped microcrystalline silicon layer is controlled to be 40 nm to 70 nm, and the thickness of the p-type doped microcrystalline silicon layer is controlled to be 40 nm to 70 nm. In the present disclosure, the thicknesses of the n-type doped microcrystalline silicon layer and the p-type doped microcrystalline silicon layer are both 40 nm to 70 nm through alkaline polishing, which can effectively improve the photoelectric performance and conversion efficiency of RESH cells.

It can be understood that the thickness of the n-type doped microcrystalline silicon layer after alkaline polishing can be, but is not limited to 40 nm, 45 nm, 50 nm, 55 nm, 60 nm, 65 nm, 70 nm; and the thickness of the p-type doped microcrystalline silicon layer after alkaline polishing can be, but is not limited to 40 nm, 45 nm, 50 nm, 55 nm, 60 nm, 65 nm, and 70 nm.

Step S600: the n-type doped microcrystalline silicon layer and the p-type doped microcrystalline silicon layer are cleaned using an acid solution containing hydrogen peroxide.

In the present disclosure, after the alkaline polishing treatment, an acid solution containing hydrogen peroxide is used to clean the n-type doped microcrystalline silicon layer and the p-type doped microcrystalline silicon layer, which can effectively remove dirt and metal ions on the surface of the microcrystalline silicon layer after alkaline polishing, and is beneficial to improving the photoelectric performance and conversion efficiency of RESH cells.

In some embodiments, the acid solution containing hydrogen peroxide is a mixed solution of hydrogen peroxide and hydrochloric acid. The silicon substrate after the alkaline polishing treatment is placed in a cleaning tank containing a mixed solution of hydrogen peroxide and hydrochloric acid for cleaning, so as to remove dirt and metal ions on the surface of the n-type doped microcrystalline silicon layer and the p-type doped microcrystalline silicon layer.

It can be understood that the specific process conditions such as the concentration of the acid solution, the concentration of hydrogen peroxide, the cleaning time, the cleaning temperature, etc. in the aforementioned cleaning treatment can be specifically determined according to the cleaning effect of the microcrystalline silicon layer, so as to effectively remove dirt and metal ions on the surface of the microcrystalline silicon layer. The process conditions of the cleaning treatment are not specifically limited in the present disclosure.

Step S700: the n-type doped microcrystalline silicon layer and the p-type doped microcrystalline silicon layer are passivated using hydrofluoric acid.

In the present disclosure, after the alkaline polishing treatment, a hydrofluoric acid solution is used to passivate the n-type doped microcrystalline silicon layer and the p-type doped microcrystalline silicon layer, which can effectively remove the oxidation layer on the surface of the microcrystalline silicon layer after alkaline polishing, and is further beneficial to improving the photoelectric performance and conversion efficiency of RESH cells.

It should be noted that, during the aforementioned passivation, specific process conditions such as the concentration of the hydrofluoric acid solution, the temperature and time of passivation can be determined based on the passivation effect of the microcrystalline silicon layer, so as to effectively remove the oxidation layer on the surface of the microcrystalline silicon layer. Accordingly, the process conditions of passivation are not specifically limited in the present disclosure.

Step S800: transparent conductive films (TCO) are deposited on the n-type doped microcrystalline silicon layer and the p-type doped microcrystalline silicon layer, respectively.

In some embodiments, a first transparent conductive film may be deposited on the n-type doped microcrystalline silicon layer by a PVD (Physical Vapor Deposition) method, and a second transparent conductive film may be deposited on the p-type doped microcrystalline silicon layer by a PVD method.

It can be understood that the specific preparation method, process conditions, deposition thickness and material type of the transparent conductive film are not specifically limited in the present disclosure.

Step S900: an electrode is prepared on the transparent conductive films.

In some embodiments, a first electrode and a second electrode are respectively prepared on the first transparent conductive film and the second transparent conductive film by screen printing or electroplating.

In some embodiments, the first electrode and the second electrode may be silver electrode or copper electrode. When the electrode is a silver electrode, it is generally prepared by screen printing. When the electrode is a copper electrode, it is generally prepared by electroplating.

A solar cell prepared by the aforementioned preparation method is provided according to some embodiments of the present disclosure. The microcrystalline silicon layer in the solar cell has a high crystallization rate and a thin thickness, and has good photoelectric performance and high conversion efficiency.

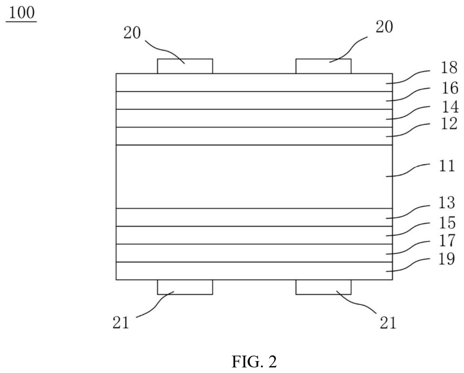

Referring to FIG. 2, in some embodiments, the solar cell 100 includes a monocrystalline silicon substrate 11, a first intrinsic amorphous silicon layer 12, a second intrinsic amorphous silicon layer 13, an n-type doped amorphous silicon layer 14, a p-type doped amorphous silicon layer 15, an n-type doped microcrystalline silicon layer 16, a p-type doped microcrystalline silicon layer 17, a first transparent conductive film 18, a second transparent conductive film 19, a first electrode 20, and a second electrode 21.

The first intrinsic amorphous silicon layer 12, the n-type doped amorphous silicon layer 14, the n-type doped microcrystalline silicon layer 16, the first transparent conductive film 18, and the first electrode 20 are sequentially stacked on a front side of the monocrystalline silicon substrate 11 (the upper surface of the monocrystalline silicon substrate 11 in FIG. 2). The second intrinsic amorphous silicon layer 13, the p-type doped amorphous silicon layer 15, the p-type doped microcrystalline silicon layer 17, the second transparent conductive film 19, and the second electrode 21 are sequentially stacked on a back side of the monocrystalline silicon substrate 11 (the lower surface of the monocrystalline silicon substrate 11 in FIG. 2).

To sum up, in the present disclosure, by regulating the deposition process parameters of the microcrystalline silicon layer and depositing the n-type doped microcrystalline silicon layer and the p-type doped microcrystalline silicon layer under specific gas pressure, gas ratio, ignition power and ignition time, the crystallization rate of the microcrystalline silicon layer is improved. In addition, through steps such as alkaline polishing, hydrogen peroxide acid solution cleaning, passivation treatment, the thickness of the microcrystalline silicon layer is reduced, and surface dirt, metal ions and oxidation layers are removed, thereby effectively improving the photoelectric performance and conversion efficiency of RESH cells.

Compared with traditional microcrystalline RESH cells, the crystallization rate of the microcrystalline silicon layer in the solar cell prepared according to the present disclosure is increased by about 10% (the crystallization rate of traditional microcrystalline RESH cells is about 43%), and its photoelectric conversion efficiency (Eta) is increased by about 0.4%. In addition, the dirt on the cell and the surface damage of the microcrystalline silicon layer are reduced, and the proportion of defective cells (scratches, suction cup marks, fingerprints, etc.) after PECVD is reduced by about 0.15%, the series resistance (Rs) of the solar cell is significantly reduced, and the short-circuit current (Isc) and fill factor (FF) are significantly improved.

The present disclosure is further described below in combination with specific examples, but they should not be construed as limiting the protection scope of the present disclosure.

### Example 1:

A first intrinsic amorphous silicon layer and a second intrinsic amorphous silicon layer were respectively deposited on a front side and a back side of a textured n-type monocrystalline silicon substrate by a PECVD method. The first intrinsic amorphous silicon layer included three intrinsic amorphous silicon layers deposited in sequence. Process gases for depositing a first layer of intrinsic amorphous silicon were SiH₄ and CO₂, a process gas pressure was 0.57 Torr, an ignition power was 650 W, a flow ratio of SiH₄ and CO₂ was 1:1, and an ignition time was 5 s. A process gas for depositing a second layer of intrinsic amorphous silicon was SiH₄, a process gas pressure was 0.57 Torr, an ignition power was 650 W, and an ignition time was 8 s. Process gases for depositing a third layer of intrinsic amorphous silicon were SiH₄ and H₂, a process gas pressure was 0.57 Torr, an ignition power was 800 W, a flow ratio of SiH₄ and H₂ was 1:1.5, and an ignition time is 7 s. The second intrinsic amorphous silicon layer also included three intrinsic amorphous silicon layers deposited in sequence, and the process conditions of each intrinsic amorphous silicon layer were the same as the process conditions of the corresponding intrinsic amorphous silicon layer when depositing the first intrinsic amorphous silicon layer.

An n-type doped amorphous silicon layer and a p-type doped amorphous silicon layer were respectively deposited on the first intrinsic amorphous silicon layer and the second intrinsic amorphous silicon layer by a PECVD method. Process gases for depositing the n-type doped amorphous silicon layer were SiH₄, PH₃ and H₂, a process gas pressure was 0.57 Torr, an ignition power was 600 W, a flow ratio of the process gases was SiH₄:PH₃=1:1, SiH₄:H₂=1:1.2, and an ignition time was 25 s. Process gases for depositing the p-type doped amorphous silicon layer were SiH₄, B₂H₆ and H₂, a process gas pressure was 0.57 Torr, an ignition power was 600 W, a flow ratio of the process gases was SiH₄:B₂H₆=1:1, SiH₄:H₂=1:1.2, and an ignition time was 25 s.

An n-type doped microcrystalline silicon layer and a p-type doped microcrystalline silicon layer were respectively deposited on the n-type doped amorphous silicon layer and the p-type doped amorphous silicon layer by a PECVD method. Process gases for depositing the n-type doped microcrystalline silicon layer were SiH₄, PH₃, and H₂, a process gas pressure was 3 Torr, flow rates of SiH₄, PH₃, and H₂ were 160 sccm, 160 sccm, and 30000 sccm, respectively, an ignition power was 2000 W, and an ignition time was 150 s. Process gases for depositing the p-type doped microcrystalline silicon layer were SiH₄, B₂H₆, and H₂, a process gas pressure was 3 Torr, flow rates of SiH₄, B₂H₆, and H₂ were 160 sccm, 160 sccm, and 30000 sccm, respectively, an ignition power was 2000 W, and an ignition time was 150 s. Thicknesses of the n-type doped microcrystalline silicon layer and the p-type doped microcrystalline silicon layer were both about 150 nm. An absorption coefficient of the microcrystalline silicon layer tested using an ellipsometer, and it was found through the absorption coefficient of the microcrystalline silicon layer that the crystallization rate of each microcrystalline silicon layer was about 55%.

The microcrystalline silicon layer was alkaline polished at 50°C using a 1% KOH solution, such that the thickness of the n-type doped microcrystalline silicon layer was reduced to 60 nm, and the thickness of the p-type doped microcrystalline silicon layer was also reduced to 60 nm.

The silicon wafer after alkaline polishing was cleaned using a hydrochloric acid solution containing hydrogen peroxide, so as to remove dirt and metal ions on the surface of the microcrystalline silicon layer. A mass fraction of hydrogen peroxide in the hydrochloric acid solution was 30%, a mass fraction of hydrochloric acid was 37%, and a cleaning time was 15 s.

The silicon wafer cleaned with the hydrochloric acid solution was passivated in a hydrofluoric acid solution, so as to remove the oxidation layer on the surface of the microcrystalline silicon layer. A mass fraction of hydrofluoric acid was 49%, and a passivation treatment time was 10 s.

A first transparent conductive film and a second transparent conductive film were respectively deposited on the n-type doped microcrystalline silicon layer and the p-type doped microcrystalline silicon layer after passivation, and then a first electrode and a second electrode were respectively prepared on the first transparent conductive film and the second transparent conductive film to obtain a RESH cell.

The photoelectric performance and conversion efficiency of the prepared RESH cell were tested. The electrical performance of the cell was tested by simulating sunlight and then contacting the cell electrodes with probes. The specific test results are shown in Table 1.

### Example 2:

The cell preparation method of this example was basically the same as that of Example 1, with the only difference lied in that in the step of depositing an n-type doped microcrystalline silicon layer and a p-type doped microcrystalline silicon layer on the n-type doped amorphous silicon layer and the p-type doped amorphous silicon layer respectively by a PECVD method, the ignition power of the microcrystalline film layer was adjusted to 2500 W. The thicknesses of the n-type doped microcrystalline silicon layer and the p-type doped microcrystalline silicon layer after thinning by alkaline polishing were the same as that in Example 1.

The photoelectric performance and conversion efficiency of the prepared cell were tested. The test method was the same as that in Example 1, and the specific test results are shown in Table 1.

### Example 3:

The cell preparation method of this example was basically the same as that of Example 1, with the only difference lied in that in the step of depositing an n-type doped microcrystalline silicon layer and a p-type doped microcrystalline silicon layer on the n-type doped amorphous silicon layer and the p-type doped amorphous silicon layer respectively by a PECVD method, the ignition power of the microcrystalline film layer was adjusted to 3000 W. The thicknesses of the n-type doped microcrystalline silicon layer and the p-type doped microcrystalline silicon layer after thinning by alkaline polishing were the same as that in Example 1.

The photoelectric performance and conversion efficiency of the prepared cell were tested. The test method was the same as that in Example 1, and the specific test results are shown in Table 1.

### Example 4:

The cell preparation method of this example was basically the same as that of Example 1, with the only difference lied in that in the step of depositing an n-type doped microcrystalline silicon layer and a p-type doped microcrystalline silicon layer on the n-type doped amorphous silicon layer and the p-type doped amorphous silicon layer respectively by a PECVD method, the ignition power of the microcrystalline film layer was adjusted to 3500 W. The thicknesses of the n-type doped microcrystalline silicon layer and the p-type doped microcrystalline silicon layer after thinning by alkaline polishing were the same as that in Example 1.

The photoelectric performance and conversion efficiency of the prepared cell were tested. The test method was the same as that in Example 1, and the specific test results are shown in Table 1.

**Table 1**

| Group | Eta[%] | Uoc[V] | Isc[mA] | FF[%] | Rs[mΩ] |
|---|---|---|---|---|---|
| Example 1 | 24.36 | 0.7486 | 8.607 | 83.35 | 3.127 |
| Example 2 | 24.43 | 0.7482 | 8.593 | 83.79 | 3.066 |
| Example 3 | 24.55 | 0.7458 | 8.641 | 83.98 | 2.521 |
| Example 4 | 24.74 | 0.7477 | 8.664 | 84.20 | 2.544 |

In Table 1, Eta is the conversion efficiency of the cell; Uoc is the open-circuit voltage of the cell; Isc is the short-circuit current of the cell; FF is the fill factor of the cell; and Rs is the series resistance of the cell.

It can be seen from the data in Table 1 that in the step of depositing the n-type doped microcrystalline silicon layer and the p-type doped microcrystalline silicon layer, within the ignition power range of 2000 W to 3500 W, the higher the ignition power, the more obvious the improvement of Isc and FF of the cell, and the higher the corresponding cell conversion efficiency (Eta). The greater the ignition power, the greater the deposition rate of the microcrystalline silicon film layer and the greater the crystallization rate of the film layer.

Each of the technical features of the aforementioned embodiments can be combined arbitrarily. To simplify the description, not all the possible combinations of the technical features in the aforementioned embodiments are described. However, all of the combinations of these technical features should be considered as within the scope of the present disclosure, as long as such combinations do not contradict with each other.

The aforementioned embodiments merely illustrate several embodiments of the present disclosure, and the description thereof is specific and detailed, but it shall not be constructed as limiting the scope of the disclosure. It should be noted that a plurality of variations and modifications may be made by those skilled in the art without departing from the conception of the present disclosure, which are all within the protection scope of the present disclosure. Accordingly, the scope of protection of the present disclosure shall be based on the appended claims, and the description and the accompanying drawings may be used to interpret the content of the claims.

## Claims

1. A method for preparing a solar cell, comprising:
providing a textured monocrystalline silicon substrate;
depositing a first intrinsic amorphous silicon layer and a second intrinsic amorphous silicon layer on a front side and a back side of the monocrystalline silicon substrate, respectively;
depositing an n-type doped amorphous silicon layer on the first intrinsic amorphous silicon layer by a PECVD method; depositing a p-type doped amorphous silicon layer on the second intrinsic amorphous silicon layer by a PECVD method;
depositing an n-type doped microcrystalline silicon layer on the n-type doped amorphous silicon layer by a PECVD method; depositing a p-type doped microcrystalline silicon layer on the p-type doped amorphous silicon layer by a PECVD method; wherein a gas pressure for depositing the n-type doped microcrystalline silicon layer and the p-type doped microcrystalline silicon layer is 3 Torr to 5 Torr, a flow ratio of SiH₄, doping gas, and H₂ in a process gas is 1: (1-1.5): (150-200), an ignition power is 2000 W to 3500 W, and an ignition time is 100 s to 230 s;
alkaline polishing the n-type doped microcrystalline silicon layer and the p-type doped microcrystalline silicon layer using an alkaline solution;
depositing transparent conductive films on the n-type doped microcrystalline silicon layer and the p-type doped microcrystalline silicon layer after alkaline polishing, respectively; and
preparing an electrode on the transparent conductive films.

2. The method for preparing the solar cell according to claim 1, wherein the alkaline solution is an alkali metal hydroxide solution with a mass fraction of 0.5% to 1.2%.

3. The method for preparing the solar cell according to claim 1 or 2, wherein a temperature of alkaline polishing is 45°C to 60°C.

4. The method for preparing the solar cell according to any one of claims 1 to 3, wherein prior to alkaline polishing, a thickness of the n-type doped microcrystalline silicon layer is 100 nm to 150 nm.

5. The method for preparing the solar cell according to any one of claims 1 to 4, wherein prior to alkaline polishing, a thickness of the p-type doped microcrystalline silicon layer is 100 nm to 150 nm.

6. The method for preparing the solar cell according to any one of claims 1 to 5, wherein after alkaline polishing, the thickness of the n-type doped microcrystalline silicon layer is 40 nm to 70 nm.

7. The method for preparing the solar cell according to any one of claims 1 to 6, wherein after alkaline polishing, the thickness of the p-type doped microcrystalline silicon layer is 40 nm to 70 nm.

8. The method for preparing the solar cell according to any one of claims 1 to 7, wherein a gas pressure for depositing the n-type doped amorphous silicon layer is 0.50 Torr to 0.57 Torr, a flow ratio of SiH₄, doping gas, and H₂ in a process gas is 1: (0.25-1): (1-1.5), an ignition power is 200 W to 800 W, and an ignition time is 20 s to 35 s.

9. The method for preparing the solar cell according to any one of claims 1 to 8, wherein a gas pressure for depositing the p-type doped amorphous silicon layer is 0.50 Torr to 0.57 Torr, a flow ratio of SiH₄, doping gas, and H₂ in a process gas is 1: (0.25-1): (1-1.5), an ignition power is 200 W to 800 W, and an ignition time is 20 s to 35 s.

10. The method for preparing the solar cell according to any one of claims 1 to 9, wherein a thickness of the n-type doped amorphous silicon layer is 3 nm to 8 nm.

11. The method for preparing the solar cell according to any one of claims 1 to 10, wherein a thickness of the p-type doped amorphous silicon layer is 3 nm to 8 nm.

12. The method for preparing the solar cell according to any one of claims 1 to 11, wherein after alkaline polishing and prior to depositing transparent conductive films, the method further comprises a step of cleaning the n-type doped microcrystalline silicon layer and the p-type doped microcrystalline silicon layer.

13. The method for preparing the solar cell according to claim 12, wherein a cleaning solution used in the cleaning is an acid solution containing hydrogen peroxide.

14. The method for preparing the solar cell according to claim 12 or 13, wherein after cleaning and prior to depositing transparent conductive films, the method further comprises a step of passivating the n-type doped microcrystalline silicon layer and the p-type doped microcrystalline silicon layer.

15. The method for preparing the solar cell according to claim 14, wherein a passivation solution used in the passivating is a hydrofluoric acid solution.

16. The method for preparing the solar cell according to any one of claims 1 to 15, wherein the first intrinsic amorphous silicon layer comprises three intrinsic amorphous silicon layers sequentially deposited on the front side of the monocrystalline silicon substrate;
wherein process gases for depositing a first layer of intrinsic amorphous silicon are SiH₄ and CO₂, a process gas pressure is 0.5 Torr to 0.57 Torr, an ignition power is 600 W to 800 W, a flow ratio of SiH₄ and CO₂ is 1:1 to 1.5, and an ignition time is 5 s to 8 s;
wherein a process gas for depositing a second layer of intrinsic amorphous silicon is SiH₄, a process gas pressure is 0.5 Torr to 0.57 Torr, an ignition power is 600 W to 800 W, and an ignition time is 8 s to 13 s;
wherein process gases for depositing a third layer of intrinsic amorphous silicon are SiH₄ and H₂, a process gas pressure is 0.5 Torr to 0.57 Torr, an ignition power is 600W to 800 W, a flow ratio of SiH₄ and H₂ is 1:1 to 1.5, and an ignition time is 3 s to 7 s.

17. The method for preparing the solar cell according to any one of claims 1 to 16, wherein the second intrinsic amorphous silicon layer comprises three intrinsic amorphous silicon layers sequentially deposited on the back side of the monocrystalline silicon substrate;
wherein process gases for depositing a first layer of intrinsic amorphous silicon are SiH₄ and CO₂, a process gas pressure is 0.5 Torr to 0.57 Torr, an ignition power is 600 W to 800 W, a flow ratio of SiH₄ and CO₂ is 1:1 to 1.5, and an ignition time is 5 s to 8 s;
wherein a process gas for depositing a second layer of intrinsic amorphous silicon is SiH₄, a process gas pressure is 0.5 Torr to 0.57 Torr, an ignition power is 600 W to 800 W, and an ignition time is 8 s to 13 s;
wherein process gases for depositing a third layer of intrinsic amorphous silicon are SiH₄ and H₂, a process gas pressure is 0.5 Torr to 0.57 Torr, an ignition power is 600W to 800 W, a flow ratio of SiH₄ and H₂ is 1:1 to 1.5, and an ignition time is 3 s to 7 s.

18. A solar cell prepared by the method for preparing the solar cell according to any one of claims 1 to 17.

19. The solar cell according to claim 18, comprising a monocrystalline silicon substrate, a first intrinsic amorphous silicon layer, a second intrinsic amorphous silicon layer, an n-type doped amorphous silicon layer, a p-type doped amorphous silicon layer, an n-type doped microcrystalline silicon layer, a p-type doped microcrystalline silicon layer, a first transparent conductive film, a second transparent conductive film, a first electrode, and a second electrode;
wherein the first intrinsic amorphous silicon layer, the n-type doped amorphous silicon layer, the n-type doped microcrystalline silicon layer, the first transparent conductive film, and the first electrode are sequentially stacked on a front side of the monocrystalline silicon substrate; and
wherein the second intrinsic amorphous silicon layer, the p-type doped amorphous silicon layer, the p-type doped microcrystalline silicon layer, the second transparent conductive film, and the second electrode are sequentially stacked on a back side of the monocrystalline silicon substrate.

20. The solar cell according to claim 19, wherein a thickness of the n-type doped microcrystalline silicon layer and a thickness of the p-type doped microcrystalline silicon layer are each independently 40 nm to 70 nm.

21. The solar cell according to claim 19 or 20, wherein a crystallization rate of the n-type doped microcrystalline silicon layer and a crystallization rate of the p-type doped microcrystalline silicon layer are each independently 45% to 55%.

22. The solar cell according to any one of claims 19 to 21, wherein a thickness of the n-type doped amorphous silicon layer and a thickness of the p-type doped amorphous silicon layer are each independently 3 nm to 8 nm.
